# EUROPÄISCHE PATENTSCHRIFT

(11) **EP 0 410 188 B1**
(45) Veröffentlichungstag und Bekanntmachung des Hinweises auf die Patenterteilung: **02.11.1994**
(21) Anmeldenummer: 90112999.9
(22) Anmeldetag: 07.07.1990
(51) Int. Cl.: H03K 17/08, H02H 3/08, H02H 7/122

(54) **Schaltungsanordnung zum Schutz eines getakteten Halbleiterschalters**
Circuit arrangement for protecting a clocked semi-conductor switch
Montage pour la protection d'un commutateur rythmé à semi-conducteur

(30) Priorität: 27.07.1989 DE 3924824
(43) Veröffentlichungstag der Anmeldung: 30.01.1991
(73) Patentinhaber: TEMIC TELEFUNKEN microelectronic GmbH, 74072 Heilbronn (DE)
(72) Erfinder: Sedlmeier, Reinhold, D-8069 Niederlauterbach (DE)
(74) Vertreter: Maute, Hans-Jürgen, Dipl.-Ing.

(56) Entgegenhaltungen:
- EP-A- 0 321 663
- DE-C- 3 121 754
- GB-A- 2 028 047
- GB-A- 2 194 108

## Beschreibung

Die Erfindung betrifft eine Schaltungsanordnung zum Schutz eines mit seiner Schaltstrecke in einem Laststromkreis liegenden, getakteten Halbleiterschalters gemäß dem Oberbegriff des Anspruches 1.

Eine solche Schutzschaltung ist aus der DE-OS 3539646 bekannt, wonach der zum Speisen von Wechselstromlasten verwendete Halbleiterschalter vor der Zerstörung durch Wärme sowie vor Überlast dynamisch regelnd durch einen Leistungsbegrenzer geschützt wird, der ein Spitzenstrom-Begrenzungsnetzwerk sowie ein Effektivstrom-Begrenzungsnetzwerk aufweist. Hierbei ist das Spitzenstrom-Begrenzungsnetzwerk zur Begrenzung des höchst zulässigen Stromes erforderlich, während das Effektivstrom-Begrenzungsnetzwerk dafür vorgesehen ist, um fortlaufend ein Maß für die im Transistor umgesetzte Verlustleistung zu haben, also den höchst zulässigen Effektivstrom innerhalb der gewünschten Grenzen zu halten und gegebenenfalls den ihn bedingenden Strom abzuschalten, damit der Schalttransistor abkühlen kann. Die Abkühldauer bestimmt ein Zeitformer, der so dimensioniert werden kann, daß bei Erreichen oder Überschreiten des maximalen Effektivstromes die Abkühldauer ausreichend ist.

Diese bekannte Schaltung weist jedoch den Nachteil auf, daß der Zeitformer für jeden Anwendungsfall neu dimensioniert werden muß, d.h. an die jeweiligen Eigenschaften des Halbleiterschalters anzupassen ist. Ferner ist diese Schaltungsanordnung äußerst unflexibel in bezug auf das Einschaltkriterium, das lediglich den Wert des höchst zulässigen Stromes sowie den Wert des höchst zulässigen Effektivstromes begrenzt und nicht auch andere Kriterien, wie beispielsweise die Anzahl der in einer bestimmten Zeitdauer auftretenden Störfälle, zuläßt.

Die Aufgabe der vorliegenden Erfindung besteht daher darin, eine Schaltungsanordnung zum Schutz eines getakteten Halbleiterschalters der eingangs genannten Art anzugeben, die eine einfache und flexible Anpassung an den zu schützenden Halbleiterschalter erlaubt und je nach Bedarf unterschiedliche Einschaltkriterien zuläßt.

Diese Aufgabe wird durch die kennzeichnenden Merkmale des Anspruches 1 gelöst.

Die erfindungsgemäße Schaltungsanordnung erlaubt ein annähernd verzögerungsfreies Abschalten des Laststromkreises bei Überschreiten des höchst zulässigen Laststromes. Der Halbleiterschalter bleibt zunächst gesperrt; diese Schaltungsanordnung ist also selbsthaltend, wobei erst das von der Steuereinheit dem Eingang des Schmitt-Triggers zugeführte Steuersignal das Einschalten des Laststromkreises erlaubt. Die Sperrdauer des Halbleiterschalters, also die Zeitdauer vom Abschalten des Last stromkreises bis zu dessen Einschalten wird softwaremäßig durch die Steuereinheit, beispielsweise ein Mikroprozessor eingestellt, wodurch je nach den zu erfüllenden Randbedingungen oder übergeordneten Gesichtspunkten Einschaltkriterien realisierbar sind. So kann sich beispielsweise die Sperrdauer von der Anzahl der während einer bestimmten Zeitdauer auftretenden Störfälle ab hängig sein, oder die Sperrung so lange andauern, bis die die Störfälle auslösende Ursache beseitigt ist. Hierzu kann diese Schaltungsanordnung in ein übergeordnetes Steuersystem eingebettet sein, an das die Steuereinheit die Störfälle meldet. Ferner kann die Sperrdauer auch von der aktuellen Temperatur des Halbleiterschalters abhängen, wobei die Temperatur über einen Temperaturmeßfühler der Steuereinheit zuzuführen ist. Schließlich gibt es noch Einschaltkriterien, die in einem übergeordneten Steuersystem begründet sind. Darüber hinaus ist diese erfindungsgemäße Schaltungsanordnung sehr servicefreundlich, da der Einsatz einer Steuereinheit, also beispielsweise eines Mikroprozessors, eine bessere Analyse der aufgetretenen Störfällen erlaubt.

Vorteilhafte Ausführungsformen der Erfindung sind in den abhängigen Ansprüchen näher gekennzeichnet.

Die Erfindung soll im folgenden anhand von Ausführungsbeispielen in Verbindung mit den Zeichnungen näher beschrieben und erläutert werden. Es zeigen:
- Figur 1: eine Übertragungskennlinie eines Schmitt-Triggers,
- Figuren 2 - 5: jeweils ein Blockschaltbild eines Ausführungsbeispieles der erfindungsgemäßen Schaltungsanordnung,
- Figur 6: ein detailliertes Schaltbild eines Ausführungsbeispieles gemäß Figur 5, und
- Figur 7: Impulsdiagramme zur Erklärung der Funktion der Schaltung gemäß Figur 6.

In den Figuren sind einander entsprechende Teile mit dem gleichen Bezugszeichen versehen.

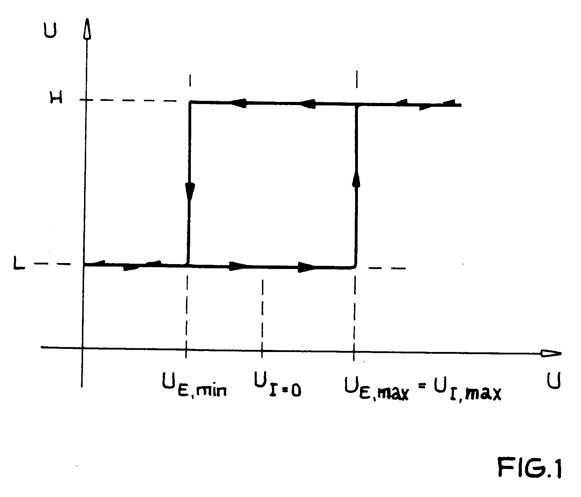

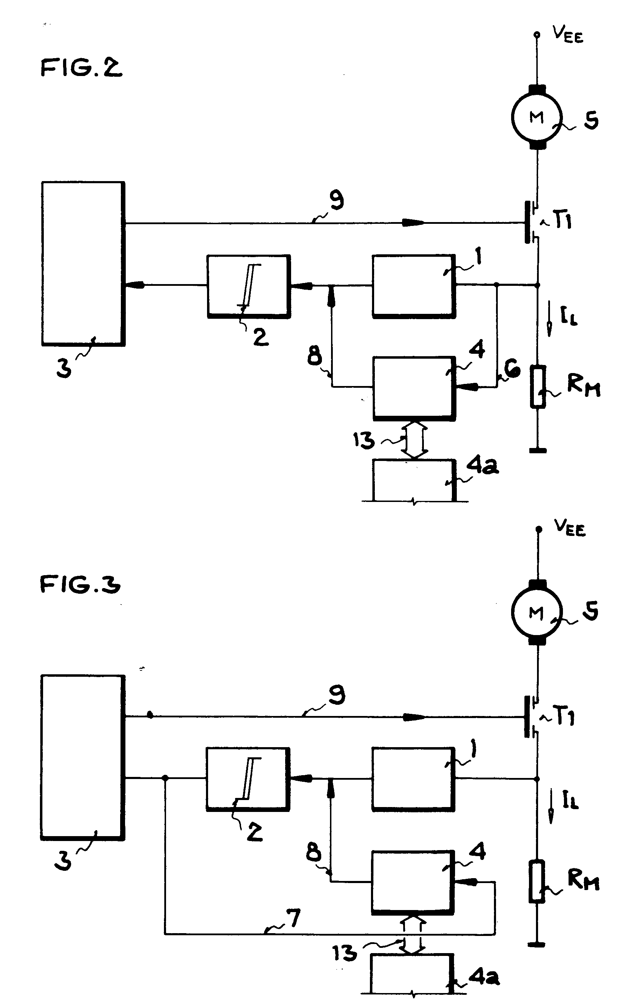

Im folgenden soll das erfindungsgemäße Verfahren anhand der Schaltungsanordnung der Figur 2 in Verbindung mit der Übertragungskennlinie eines Schmitt-Triggers gemäß Figur 1 erläutert werden. In der Figur 2 besteht ein Laststromkreis aus der seriellen Verschaltung eines Gleichstrommotores 5, eines Feldeffekttransistors T₁ sowie eines Meßwiderstandes R_{M}, wobei dieser Laststromkreis über den Gleichstrommotor 5 auf einem Betriebspotential V_{EE} und über einen Anschluß des Meßwiderstandes R_{M} auf dem Bezugspotential der Schaltung liegt. Schließlich ist mit den Bezugszeichen 1, 2, 3, 4 und 4a ein Istwert-Geber, ein Schmitt-Trigger, eine Steuerschaltung, eine Steuereinheit sowie ein übergeordnetes Steuersystem bezeichnet. Der von dem Laststrom I_{L} an dem Meßwiderstand R_{M} erzeugte Spannungsabfall wird sowohl dem Istwert-Geber als auch über eine Leitung 6 der Steuereinheit 4 zugeführt. Der Eingang des Schmitt-Triggers 2 wird sowohl von dem Istwert-Geber 1 als auch über eine Leitung 8 von der Steuereinheit 4 angesteuert. Zwischen der Steuereinheit 4 und dem übergeordneten Steuersystem 4a besteht eine bidirektionale Datenleitung 13. Schließlich erhält die Steuerschaltung 3 vom Ausgang des Schmitt-Triggers ihre Steuerimpulse, während sie ihrerseits über eine Leitung 9 die Gate-Elektrode des als Halbleiterschalter arbeitenden Feldeffekttransistors T₁ ansteuert. Der Istwert-Geber 1 erzeugt während des störungsfreien Betriebes in Abhängigkeit des an dem Meßwiderstand R_{M} abgegriffenen Spannungspegels einen dem Schmitt-Trigger 2 zuzuführenden Istwert, der größer ist als die untere Trigger-Schwelle U_{E,min} des Schmitt-Triggers 2 gemäß der in Figur 1 dargestellten Übertragungskennlinie. Dies bedeutet bei Stillstand des Gleichmotors 5 mit einem Wert Null des Lastmomentes, daß der Laststrom I_{L} null ist und der entsprechende Istwert U_{I=O} zwischen der unteren Trigger-Schwelle U_{E,min} und der oberen Trigger- Schwelle U_{E,max} liegt.

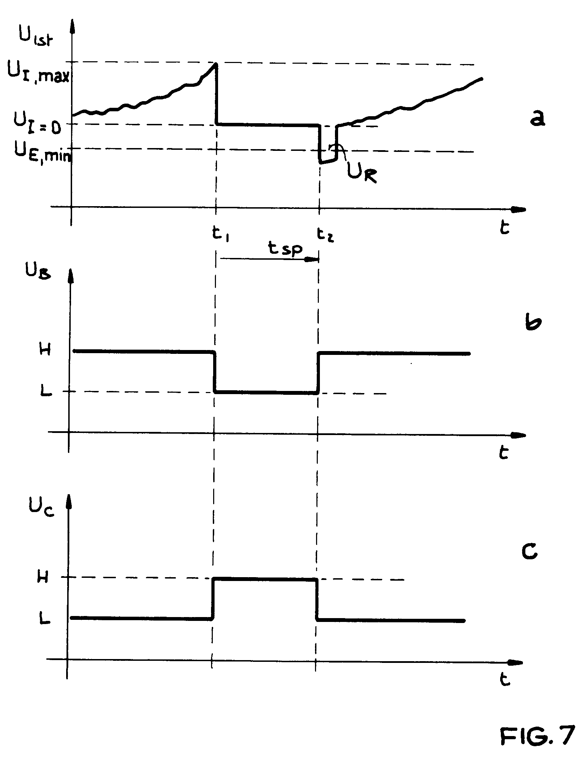

Läuft der Gleichstrommotor 5 an, so nimmt auch der Istwert zu, bis der Laststrom I_{L} bei einem Störfall den höchst zulässigen Wert übersteigt, das heißt, der Istwert U_{Ist} erreicht die obere Trigger-Schwelle U_{E,max}. Nun schaltet der Ausgang des Schmitt-Triggers 2 um, wodurch also anstatt des Low-Pegels L ein High-Pegel H der Steuerschaltung 3 zugeführt wird. Hierdurch wird die Steuerschaltung 3 veranlaßt, über ein entsprechendes Steuersignal den Feldeffekttransistor T₁ zu sperren. Dadurch geht der Laststrom I_{L} auf den Wert O zurück, der entsprechende Istwert U_{I=O} erreicht jedoch nicht die untere Trigger-Schwelle U_{E,min}, was zur Folge hat, daß der Feldeffekttransistor T₁ gesperrt bleibt. Nach Ablauf der Sperrdauer tₛₚ, die softwaremäßig in der Steuereinheit 4 festgelegt ist, gibt diesselbe einen Reset-Impuls U_{R} auf den Eingang des Schmitt-Triggers 2 ab, wobei der Spannungspegel dieses Reset-Impulses U_{R} kleiner als die untere Trigger-Schwelle U_{E,min} ist, was dessen Umschalten bewirkt. Die Figur 7a zeigt ein Beispiel für den Spannungsverlauf eines Istwertes, wonach bis zu einem Zeitpunkt t₁ der Istwert im Bereich zwischen dem Spannungswert U_{I=O} und dem Spannungswert U_{I,max}, verläuft und erst zum Zeitpunkt t₁ den Spannungswert U_{E,max}, also die obere Trigger-Schwelle erreicht, mit der Folge, daß der Istwert auf den Spannungswert U_{I=O} absinkt und für die Zeitdauer tₛₚ auf diesem Niveau verharrt. Nach Ablauf dieser Sperrdauer tₛₚ, also zum Zeitpunkt t₂, sendet die Steuereinheit 4 einen Reset-Impuls U_{R}, wodurch wieder über die Steuerschaltung 3 eine getaktete Ansteuerung des Feldeffekttransistors T₁ erfolgt und der Spannungspegel des Istwertes U_{Ist} wieder ansteigt. Die Sperrdauer tₛₚ ist softwaremäßig festgelegt, wobei die Steuereinheit 4, die über die Datenleitung 13 von dem übergeordneten Steuersystem zugeführte Informationen verwerten kann.

Zur Auswertung wird auch der an dem Meßwiderstand auftretende Spannungsabfall über die Leitung 6 der Steuereinheit 4 zugeführt, wodurch beispielsweise jeder Störfall detektierbar ist und in Abhängigkeit davon die Sendung des Reset-Impulses U_{R} erfolgt.Die Verarbeitung eines Störfalles erfolgt jedoch relativ langsam, da die in der Steuereinheit 4 auszuführende zeitdiskrete Auswertung des Augenblickwertes aufgrund des in der Steuereinheit 4 vorhandenen A/D-Wandlers den kritischen Strom nicht schnell genug erfassen kann.

Ein diesen Nachteil vermeidendes Beispiel einer erfindungsgemäßen Schaltungsanordnung zeigt die Figur 3, die in wesentlichen Teilen mit derjenigen nach Figur 2 übereinstimmt, wobei jedoch statt der Leitung 6 eine Leitung 7 vom Ausgang des Schmitt-Triggers 2 zur Steuereinheit 4 führt, wodurch der im Fall eines Störfalles auftretende High-Pegel am Ausgang des Schmitt-Triggers 2 zur schnellen Detektion dieses Störfalles an die Steuereinheit 4 zugeführt wird.

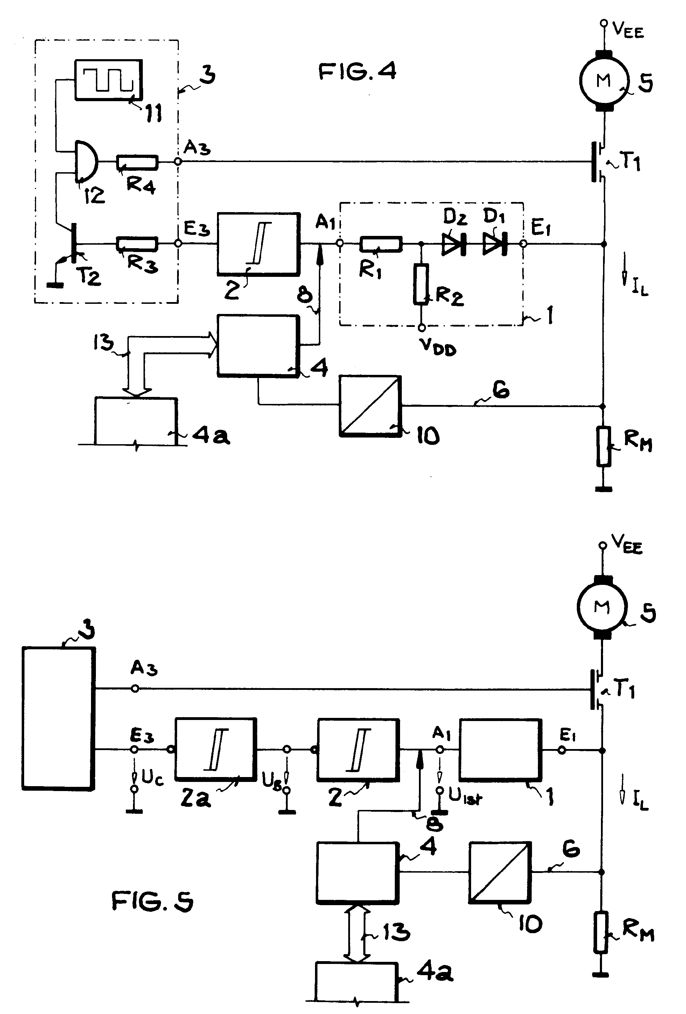

In Figur 4 ist eine detailliertere Darstellung der Schaltungsanordnung gemäß Figur 2 dargestellt. Hiernach besteht der Istwert-Geber 1 aus einer ersten und zweiten Diode D₁ und D₂ sowie einem ersten und zweiten Widerstand R₁ bzw. R₂. Hierbei ist die Kathode der ersten Diode D₁ an den Eingang E₁ des Istwert-Gebers 1 angeschlossen, während deren Anode mit der Kathode der zweiten Diode D₂ verbunden ist. Schließlich ist die Anode dieser zweiten Diode D₂ sowohl über den ersten Widerstand R₁ mit dem Ausgang A₁ des Istwert-Gebers 1 als auch über den zweiten Widerstand R₂ an eine Betriebsspannungsquelle V_{DD} angeschlossen.

Die Steuerschaltung 3 besteht gemäß dieser Figur 4 aus einem Impulsgenerator 11, einem AND-Gatter 12 mit zwei Eingängen und einem Ausgang sowie einem ersten und zweiten Widerstand R₃ bzw. R₄ und einem Steuertransistor T₂. Hierbei führt der Pulsgenerator 11 ein pulsbreitenmoduliertes Signal auf den einen Eingang des AND-Gatters 12, während dessen anderer Eingang von der KollektorElektrode des Steuertransistors T₂ angesteuert wird. Der Ausgang des AND-Gatters 12 steuert über den zweiten Widerstand R₄ den Ausgang A₃ der Steuerschaltung an. Der Eingang E₃ dieser Steuerschaltung 3 ist über den ersten Widerstand R₃ mit der Basis-Elektrode des Steuertransistors T₂ verbunden, während dessen Emitter-Elektrode auf dem Bezugspotential der Schaltung liegt.

Der Spannungspegel des an dem Meßwiderstand R_{M} auftretenden Spannungsabfalles wird einem der Steuereinheit 4 vorgeschalteten Pegelwandler 10 zugeführt, der diesen Spannungspegel an den Eingangspegel der Steuereinheit 4 anpaßt.

Die Betriebsspannungsquelle V_{EE} für den Laststromkreis weist eine Betriebsspannung von ca. 300 V auf, während diejenige der Betriebsspannungsquelle V_{DD} für den Istwert-Geber 1 ca. 5 V beträgt.

Die beiden Dioden D₁ und D₂ des Istwert-Gebers 1 dienen in Verbindung mit den beiden Widerständen R₁ und R₂ dazu, um zum Zeitpunkt t₁ - siehe Figur 7a - eine Vorspannung an den Eingang des Schmitt-Triggers 2 zu legen, die größer als die untere Trigger-Schwelle ist, U_{E,min} ist, also dem Spannungswert U_{I=O} entspricht.

Schaltet der Schmitt-Trigger 2 seinen Ausgang auf einen High-Pegel, wird der Steuertransistor T₂ der Steuerschaltung 3 leitend, wodurch an dem entsprechenden Eingang des AND-Gatters das Bezugspotential der Schaltung anliegt, d. h., daß am Ausgang des AND-Gatters 12 ein Low-Pegel erscheint, wodurch der Feldeffekt-Transistor T₁ in den sperrenden Zustand versetzt wird. Wird jedoch ein Reset-Impuls durch die Steuerschaltung 4 auf den Eingang des Schmitt-Triggers 2 gegeben, erscheint an dessen Ausgang ein Low-Pegel, wodurch der Steuertransistor T₂ der Steuerschaltung 3 in den sperrenden Zustand übergeht, mit der Folge, daß am entsprechenden Eingang des AND-Gatters 12 ein High-Pegel ansteht, wodurch die pulsbreitenmodulierten Impulse des Pulsgenerators 11 auf den Ausgang A3 der Steuerschaltung 3 geleitet werden.

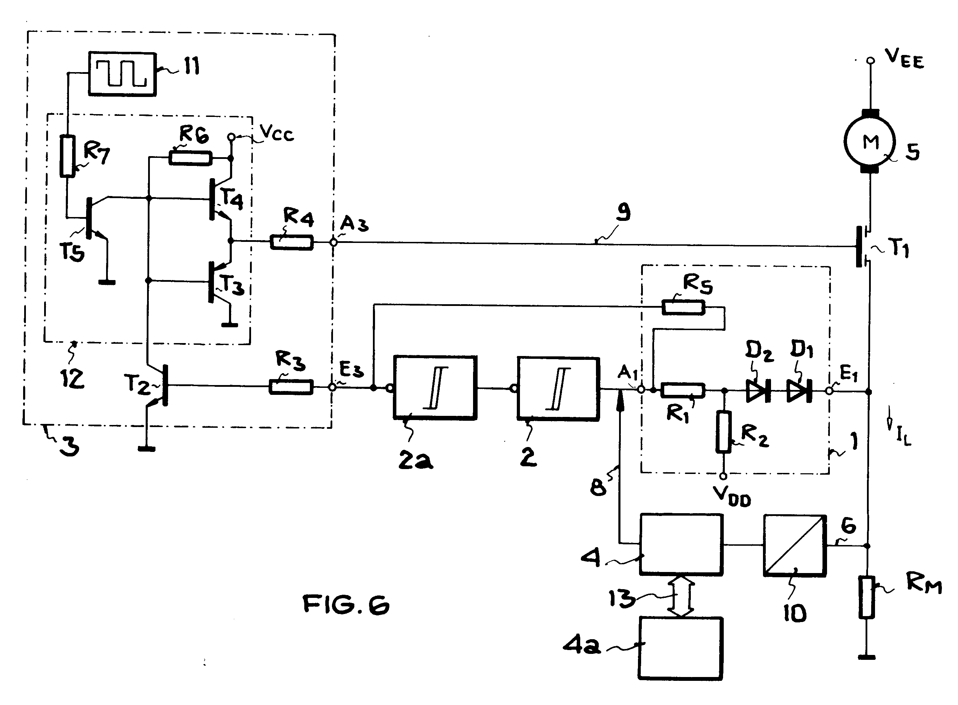

Die Schaltungsanordnung der Figur 5 entspricht im wesentlichen derjenigen der Figur 2, mit dem Unterschied, daß der Schmitt-Trigger 2 ein Schmitt-Trigger mit negiertem Ausgang ist und diesem Schmitt-Trigger 2 ein weiterer Schmitt-Trigger 2a mit negiertem Ausgang nachgeschaltet ist. Die entsprechenden Impuls-Diagramme für ein Beispiel eines Störfalles ist in den Figuren 7a, b und c dargestellt, wonach der Spannungsverlauf U_{Ist} des Ist-Wertes am Eingang des Schmitt-Triggers 2, der Spannungsverlauf U_{B} am Ausgang des Schmitt-Triggers 2 sowie der Spannungsverlauf U_{C} am Ausgang des weiteren Schmitt-Triggers 2a gezeigt ist. Bewegt sich die Spannung U_{Ist} des Ist-Wertes zwischen den Spannungswerten U_{I=O} und U_{I,max}, liegt der Spannungspegel U_{B} am Ausgang des Schmitt-Triggers 2 auf dem High-Pegel, während gleichzeitig der Spannungswert U_{C} am Ausgang des weiteren Schmitt-Triggers 2a auf dem Low-Pegel bleibt; dies entspricht einem störungsfreien Betrieb der Last. Nachdem der Spannungspegel des Ist-Wertes U_{Ist} die obere Triggerschwelle U_{E,max} = U_{I,max} zum Zeitpunkt t₁ erreicht hat, wenn also ein Störfall eingetreten ist, schaltet der Ausgang des Schmitt-Triggers 2 auf den Low-Pegel, wodurch gleichzeitig der weitere Schmitt-Trigger 2a auf den High-Pegel schaltet. Nach Ablauf der Sperrdauer tₛₚ, also zum Zeitpunkt t₂, bewirkt der Reset-Impuls U_{R} ein Umschalten des Schmitt-Triggers 2 auf den High-Pegel, wodurch ein Umschalten des weiteren Schmitt-Triggers 2a auf den Low-Pegel bewirkt wird.

Eine detaillierte Ausführung der Schaltungsanordnung gemäß Figur 5 zeigt nun die Figur 6. Hierbei entspricht der Istwert-Geber 1 in seinem Aufbau demjenigen gemäß der Figur 4, wobei zusätzlich ein Widerstand R₅ den Ausgang A1 des Istwert-Gebers 1 mit dem Ausgang des weiteren Schmitt-Triggers 2a verbindet. Mit dem Verhältnis der Widerstandswerte der beiden Widerstände R₁ und R₅ kann die Hysterese der Schmitt-Trigger vergrößert und somit auf die erforderlichen Werte eingestellt werden.

Das AND-Gatter 12 besteht bei dieser Schaltungsanordnung aus einem ersten pnp-Transistor T₃, einem zweiten und dritten npn-Transistor T₄ und T₅, wobei die KollektorElektrode des ersten Transistors T₃ auf dem Bezugspotential der Schaltung liegt und dessen Emitter-Elektrode sowie die Emitter-Elektrode des zweiten Transistors T₄ den Ausgang des AND-Gatters 12 bilden. Dagegen sind die Basis-Elektroden des ersten und zweiten Transistors T₃ und T₄ und die Kollektor-Elektrode des dritten Transistors T₅ über einen ersten Widerstand R₆ mit der Kollektor-Elektrode des zweiten Transistors T₄ verbunden wobei diese Kollektor-Elektrode selbst mit einer Betriebsspannungsquelle V_{CC} verbunden ist. Schließlich liegt die Emitter-Elektrode des dritten Transistors T₅ auf dem Bezugspotential der Schaltung und dessen Basis-Elektrode ist über einen zweiten Widerstand R₇ an den Pulsgenerator 11 angeschlossen.

Die Funktion dieser in Figur 6 dargestellten Steuerschaltung 3 soll im folgenden kurz erläutert werden. Schaltet der zweite Schmitt-Trigger 2a zum Zeitpunkt t₁ auf den H-Pegel - siehe hierzu Figur 7c - , so wird der Steuertransistor T₂ der Steuerschaltung 3 leitend, mit der Folge, daß ebenso der erste Transistor T₃ des AND-Gatters 12 in den leitenden Zustand schaltet, jedoch der zweite Transistor T₄ des AND-Gatters 12 sperrt. Somit liegt der Ausgang des AND-Gatters 12 auf dem L-Pegel, was den Feldeffekttransistor T₁ in den sperrenden Zustand überführt. Dieser Zustand bleibt so lange erhalten, bis durch eine von einem zum Zeitpunkt t₂ gesendeten Reset-Impuls U_{R} ausgelöste Umschaltung auf den L-Pegel (siehe Figur 7a) am Ausgang des zweiten Schmitt-Triggers 2a den Steuertransistor T₂ sperren läßt, wodurch auch der Transistor T₃ in den sperrenden Zustand übergeht. Dies bewirkt nun einen im Rhythmus des über den Transistor T₅ der Basis des Transistors T₄ zugeführten pulsbreitenmodulierten Signals leitenden und sperrenden Transistor T₄, wodurch wieder eine Ansteuerung des Feldeffekttransistors T₁ möglich ist.

Die in den Figuren 2 - 6 dargestellten Ausführungsbeispiele der erfindungsgemäßen Schaltungsanordnung weisen jeweils als Last einen Gleichstrommotor 5 auf. Jedoch ist eine solche Schaltungsanordnung nicht nur zur Steuerung von Gleichstromlasten geeignet, sondern auch zur Steuerung von Wechselstromlasten, wobei jedoch die Ansteuerung zusätzlich über ein Gleichrichterelement erfolgen muß.

## Patentansprüche

1. Schaltungsanordnung zum Schutz eines mit seiner Schaltstrecke in einem Laststromkreis liegenden, getakteten Halbleiterschalters (T₁) mit einer Steuerschaltung (3), einem Istwert-Geber (1), der einen Istwert aus dem die Schaltstrecke des Halbleiterschalters (T₁) durchfließenden Laststrom (I_{L}) bildet, dadurch gekennzeichnet, daß ein Schmitt-Trigger (2) dem Istwert-Geber (1) nachgeschaltet ist, daß der niedrigste Spannungspegel des Istwertes größer als die untere Triggerschwelle ist und der höchste Spannungspegel des Istwertes die obere Triggerschwelle des Schmitt-Triggers (2) erreichen kann, daß, nachdem der Istwert im Störfall die obere Triggerschwelle überschritten hat, der Schaltzustand des Schmitt-Triggers (2) sich derart ändert, daß die Öffnung des Halbleiterschalters (T₁) über die Steuerschaltung (3) veranlaßt wird, daß eine Steuereinheit (4) vorgesehen ist, die nach einer softwaremäßig festgelegten Sperrdauer (tₛₚ) einen Reset-Impuls (U_{R}) erzeugt und daß dieser Reset-Impuls (U_{R}) zur Umschaltung des Schmitt-Triggers (2) dessen Eingang zugeführt wird, so daß über die Steuerschaltung (3) das betriebsmäßige getaktete Ansteuern des Halbleiterschalters (T₁) erfolgt.

2. Schaltungsanordnung nach Anspruch 1, dadurch gekennzeichnet, daß der Steuereinheit (4) ein weiterer Istwert zur Auswertung zugeführt wird, wobei der weitere Istwert aus dem die Schaltstrecke des Halbleiterschalters (T₁) durchfließenden Laststrom (I_{L}) gebildet ist.

3. Schaltungsanordnung nach Anspruch 1, dadurch gekennzeichnet, daß das Ausgangssignal des Schmitt-Triggers (2) der Steuereinheit (4) zur Auswertung zugeführt wird.

4. Schaltungsanordnung nach Anspruch 1 oder 2 mit einem in Serie zur Schaltstrecke des Halbleiterschalters (T₁) liegenden Meßwiderstand (R_{M}), dadurch gekennzeichnet, daß als Halbleiterschalter (T₁) ein Schalttransistor vorzugsweise ein Feldeffekttransistor, vorgesehen ist, daß der an dem Meßwiderstand (R_{M}) auftretende Spannungsabfall die Eingangsgröße des Istwert-Gebers (1) darstellt, daß der Istwert-Geber (1) folgende Elemente umfaßt:
Eine erste Diode (D₁), deren Kathode den Eingang (E₁) des Istwert-Gebers (1) darstellt,
eine zweite Diode (D₂), deren Kathode mit der Anode der ersten Diode (D₁) verbunden ist und deren Anode sowohl über einen ersten Widerstand (R₁) an den Ausgang (A₁) des Istwert-Gebers (1) als auch über einen zweiten Widerstand (R₂) an eine erste Betriebsspannungsquelle (V_{DD}) angeschlossen ist,
daß ferner der Ausgang der Steuereinheit (4) mit dem Eingang des Schmitt-Triggers (2) verbunden ist, daß der Ausgang des Schmitt-Triggers (2) an den Eingang (E₃) der Steuerschaltung (3) angeschlossen ist, und daß der Ausgang (A₃) der Steuerschaltung (3) die Gate-Elektrode des Feldeffekttransistors (T₁) ansteuert.

5. Schaltungsanordnung nach Anspruch 4, dadurch gekennzeichnet, daß der an dem Meßwiderstand (R_{M}) auftretende Spannungsabfall die Eingangsgröße für einen der Steuereinheit (4) vorgeschalteten Pegelwandler (10) darstellt.

6. Schaltungsanordnung nach einem der vorangehenden Ansprüche, dadurch gekennzeichnet, daß die Steuerschaltung (3) aus folgenden Elementen besteht:
Einem npn-Steuertransistor (T₂), dessen Basis-Elektrode über einen ersten Widerstand (R₃) mit dem Eingang (E₃) der Steuerschaltung (3) verbunden ist und dessen Emitter-Elektrode auf dem Bezugspotential der Schaltung liegt,
einem AND-Gatter (12), dessen erster Eingang mit der Kollektor-Elektrode des Steuertransistors (T₂) und dessen zweiter Eingang mit einem Pulsgenerator (11) verbunden ist, während dessen Ausgang über einen zweiten Widerstand (R₄) an den Ausgang (A₃) der Steuerschaltung (3) angeschlossen ist.

7. Schaltungsanordnung nach einem der vorangehenden Ansprüche, dadurch gekennzeichnet, daß der Schmitt-Trigger (2) ein Schmitt-Trigger mit negiertem Ausgang ist, und daß diesem Schmitt-Trigger (2) ein weiterer Schmitt-Trigger (2a) mit negiertem Ausgang nachgeschaltet ist.

8. Schaltungsanordnung nach Anspruch 7, dadurch gekennzeichnet, daß der Ausgang des zweiten Schmitt-Triggers (2a) über einen Widerstand (R₅) mit dem Ausgang (A₁) des Istwert-Gebers (1) verbunden ist.

9. Schaltungsanordnung nach einem der Ansprüche 6 - 8, dadurch gekennzeichnet, daß das AND-Gatter (12) der Steuerschaltung (3) folgende Elemente aufweist:
Einen ersten pnp-Transistor (T₃), dessen Kollektor-Elektrode auf dem Bezugspotential der Schaltung liegt und dessen Basis-Elektrode den ersten Eingang des AND-Gatters (12) darstellt,
einen zweiten npn-Transistor (T₄), dessen Emitter-Elektrode sowohl mit der Emitter-Elektrode des ersten Transistors (T₃) als auch mit dem Ausgang des AND-Gatters (12) verbunden ist, dessen Kollektor-Elektrode auf dem Potential einer zweiten Betriebsspannungsquelle (V_{CC}) liegt und dessen Basiselektrode einerseits mit der Basis-Elektrode des ersten Transistors (T₃) und andererseits über einen ersten Widerstand (R₆) mit seiner Kollektor-Elektrode verbunden ist,
einen dritten npn-Transistor (T₅), dessen Emitter-Elektrode auf dem Bezugspotential der Schaltung liegt, dessen Dollektor-Elektrode an die Basis-Elektrode des zweiten Transistors (T₄) angeschlossen ist und dessen Basis-Elektrode über einen zweiten Widerstand (R₇) mit dem zweiten Eingang des AND-Gatters (12) verbunden ist.

10. Schaltungsanordnung nach einem der vorangehenden Ansprüche, dadurch gekennzeichnet, daß die Steuereinheit (4) einen Mikroprozessor darstellt.

## Claims

1. Circuit arrangement for protecting a clocked semiconductor switch (T₁) whose switch section lies in a load circuit, having a control circuit (3), an actual-value sensor (1) which forms an actual value from the load current (I_{L}) flowing through the switch section of the semiconductor switch (T₁), characterized in that a Schmitt trigger (2) is connected downstream of the actual-value sensor (1), that the lowest voltage level of the actual value is greater than the lower trigger threshold and the highest voltage level of the actual value may reach the upper trigger threshold of the Schmitt trigger (2), that, after the actual value in the event of a fault has exceeded the upper trigger threshold, the circuit state of the Schmitt trigger (2) alters in such a way that the opening of the semiconductor switch (T₁) is effected via the control circuit (3), that a control unit (4) is provided which, after a software-defined blocking period (tₛₚ), generates a reset pulse (U_{R}), and that said reset pulse (U_{R}) is supplied to the input of the Schmitt trigger (2) for the purpose of switching over the Schmitt trigger so that, via the control circuit (3), the operationally clocked triggering of the semiconductor switch (T₁) is effected.

2. Circuit arrangement according to claim 1, characterized in that a further actual value is supplied to the control unit (4) for evaluation, the further actual value being formed from the load current (IL) flowing through the switch section of the semiconductor switch (T₁).

3. Circuit arrangement according to claim 1, characterized in that the output signal of the Schmitt trigger (2) is supplied to the control unit (4) for evaluation.

4. Circuit arrangement according to claim 1 or 2, having a precision resistor (R_{M}) connected in series to the switch section of the semiconductor switch (T₁), characterized in that a switching transistor, preferably a field-effect transistor, is provided as a semiconductor switch (T₁), that the voltage drop arising at the precision resistor (RM) is the input variable of the actual-value sensor (1), that the actual-value sensor (1) comprises the following elements:
a first diode (D₁), whose cathode is the input (E₁) of the actualvalue sensor (1),
a second diode (D₂), whose cathode is connected to the anode of the first diode (D₁) and whose anode is connected both via a first resistor (R₁) to the output (A₁) of the actual-value sensor (1) and via a second resistor (R₂) to a first operating voltage source (V_{DD}),
that further the output of the control unit (4) is connected to the input of the Schmitt trigger (2), that the output of the Schmitt trigger (2) is connected to the input (E₃) of the control circuit (3), and that the output (A₃) of the control circuit (3) triggers the gate electrode of the field-effect transistor (T₁).

5. Circuit arrangement according to claim 4, characterized in that the voltage drop arising at the precision resistor (RM) is the input variable for a level converter (10) connected upstream of the control unit (4).

6. Circuit arrangement according to one of the preceding claims, characterized in that the control circuit (3) comprises the following elements:
an n-p-n control transistor (T₂), whose base electrode is connected via a first resistor (R₃) to the input (E₃) of the control circuit (3) and whose emitter electrode is connected to the reference potential of the circuit,
an AND gate (12), whose first input is connected to the collector electrode of the control transistor (T₂) and whose second input is connected to a pulse generator (11), while its output is connected via a second resistor (R₄) to the output (A₃) of the control circuit (3).

7. Circuit arrangement according to one of the preceding claims, characterized in that the Schmitt trigger (2) is a Schmitt trigger with a negating output, and that connected downstream of said Schmitt trigger (2) is a further Schmitt trigger (2a) with a negating output.

8. Circuit arrangement according to claim 7, characterized in that the output of the second Schmitt trigger (2a) is connected via a resistor (R₅) to the output (A₁) of the actual-value sensor (1).

9. Circuit arrangement according to one of claims 6 to 8, characterized in that the AND gate (12) of the control circuit (3) comprises the following elements:
a first p-n-p transistor (T₃), whose collector electrode is connected to the reference potential of the circuit and whose base electrode is the first input of the AND gate (12),
a second n-p-n transistor (T₄), whose emitter electrode is connected both to the emitter electrode of the first transistor (T₃) and to the output of the AND gate (12), whose collector electrode is connected to the potential of a second operating voltage source (Vcc) and whose base electrode is connected on the one hand to the base electrode of the first transistor (T₃) and on the other hand via a first resistor (R₆) to its collector electrode,
a third n-p-n transistor (T₅), whose emitter electrode is connected to the reference potential of the circuit, whose collector electrode is connected to the base electrode of the second transistor (T₄) and whose base electrode is connected via a second resistor (R₇) to the second input of the AND gate (12).

10. Circuit arrangement according to one of the preceding claims, characterized in that the control unit (4) is a microprocessor.

## Revendications

1. Montage pour la protection d'un commutateur à semi-conducteur (T₁) rythmé, connecté par son intervalle de coupure dans un circuit de charge, comprenant un circuit de commande (3) et un transmetteur de valeur réelle (1) qui forme une valeur réelle à partir du courant de charge (I_{L}) parcourant l'intervalle de coupure du commutateur à semi-conducteur (T₁), caractérisé en ce qu'une bascule de Schmitt (2) est montée à la suite du transmetteur de valeur réelle (1), que le niveau de tension le plus bas de la valeur réelle est plus haut que le seuil inférieur de basculement et le niveau de tension le plus élevé de la valeur réelle peut atteindre le seuil supérieur de basculement de la bascule de Schmitt (2), que, après que la valeur réelle a dépassé le seuil supérieur de basculement dans le cas d'une perturbation ou panne, l'état de commutation de la bascule de Schmitt (2) change de manière que soit provoquée l'ouverture du commutateur à semi-conducteur (T₁) par l'intermédiaire du circuit de commande (3), qu'une unité de commande (4) est prévue qui, après une durée de blocage (tₛₚ) fixée au niveau du logiciel, génère une impulsion de remise à l'état initial (U_{R}), et que cette impulsion de remise à l'état initial (U_{R}) est envoyée à l'entrée de la bascule de Schmitt (2) en vue de la commutation de celle-ci, de sorte que le pilotage rythmé du commutateur à semiconducteur (T₁), prévu pour le fonctionnement, est assuré par l'intermédiaire du circuit de commande (3).

2. Montage selon la revendication 1, caractérisé en ce qu'une valeur réelle supplémentaire est envoyée pour exploitation à l'unité de commande (4), valeur réelle supplémentaire qui est formée à partir du courant de charge (I_{L}) parcourant l'intervalle de coupure du commutateur à semi-conducteur (T₁).

3. Montage selon la revendication 1, caractérisé en ce que le signal de sortie de la bascule de Schmitt (2) est envoyé pour exploitation à l'unité de commande (4).

4. Montage selon la revendication 1 ou 2 et comportant une résistance de mesure (R_{M}) montée en série avec l'intervalle de coupure du commutateur à semi-conducteur (T₁), caractérisé en ce que le commutateur à semi-conducteur (T₁) est un transistor de commutation, de préférence un transistor à effet de champ, que la chute de tension apparaissant aux bornes de la résistance de mesure (R_{M}) représente la grandeur d'entrée du transmetteur de valeur réelle (1), que le transmetteur de valeur réelle (1) comporte les éléments suivants:
une première diode (D₁) dont la cathode représente l'entrée (E₁) du transmetteur de valeur réelle (1),
une seconde diode (D₂) dont la cathode est reliée à l'anode de la première diode (D₁) et dont l'anode est connectée à la fois à la sortie (A₁) du transmetteur (1), à travers une première résistance (R₁), et à une première source de tension de service (VDD), à travers une seconde résistance (R₂),
que, en outre, la sortie de l'unité de commande (4) est reliée à l'entrée de la bascule de Schmitt (2), que la sortie de la bascule de Schmitt (2) est connectée à l'entrée (E₃) du circuit de commande (3) et que la sortie (A₃) du circuit de commande (3) pilote l'électrode de grille du transistor à effet de champ (T₁).

5. Montage selon la revendication 4, caractérisé en ce que la chute de tension apparaissant aux bornes de la résistance de mesure (R_{M}), représente la grandeur d'entrée pour un convertisseur de niveau (10) prévu en amont de l'unité de commande (4).

6. Montage selon une des revendications précédentes, caractérisé en ce que le circuit de commande (3) est composé des éléments suivants:
un transistor de commande npn (T₂) dont l'électrode de base est reliée à travers une première résistance (R₃) à l'entrée (E₃) du circuit de commande (3) et dont l'électrode d'émetteur se trouve au potentiel de référence du montage et
une porte ET (12) dont une première entrée est reliée à l'électrode de collecteur du transistor de commande (T₂) et dont la seconde entrée est reliée à un générateur d'impulsions (11), tandis que sa sortie est connectée à travers une seconde résistance (R₄) à la sortie (A₃) du circuit de commande (3).

7. Montage selon une des revendications précédantes, caractérisé en ce que la bascule de Schmitt (2) est une bascule à sortie inverseuse et que cette bascule (2) est suivie d'une bascule de Schmitt supplémentaire (2a) à sortie inverseuse.

8. Montage selon la revendication 7, caractérisé en ce que la sortie de la seconde bascule de Schmitt (2a) est reliée à travers une résistance (R₅) à la sortie (A₁) du transmetteur de valeur réelle (1).

9. Montage selon une des revendications 6 - 8, caractérisé en ce que la porte ET (12) du circuit de commande (3) comporte les éléments suivants:
un premier transistor pnp (T₃) dont l'électrode de collecteur se trouve au potentiel de référence du montage et dont l'électrode de base représente la première entrée de la porte ET (12),
un deuxième transistor npn (T₄) dont l'électrode d'émetteur est reliée à la fois à l'électrode d'émetteur du premier transistor (T₃) et à la sortie de la porte ET (12), dont l'électrode de collecteur se trouve au potentiel d'une seconde source de tension de service (V_{CC}) et dont l'électrode de base est reliée d'une part à l'électrode de base du premier transistor (T₃) et d'autre part, à travers une première résistance (R₆), à l'électrode de collecteur de ce transistor, et
un troisième transistor npn (T₆) dont l'électrode d'émetteur se trouve au potentiel de référence du montage, dont l'électrode de collecteur est connectée à l'électrode de base du deuxième transistor (T₄) et dont l'électrode de base est reliée à travers une seconde résistance (R₇) à la seconde entrée de la porte ET (12).

10. Montage selon une des revendications précédentes, caractérisé en ce que l'unité de commande (4) représente un microprocesseur.
